# EUROPEAN PATENT APPLICATION

(11) **EP 0 976 589 A1**
(43) Date of publication of application: **02.02.2000**
(21) Application number: 97915782.3
(22) Date of filing: 18.03.1997
(51) Int. Cl.: B60G 1/00

(54) **LUMINESCENT DIODE**

(71) Applicant: Obschestvo S Ogranichennoy Otvetstvennostju "Korvet Lights", Moscow, 105058 (RU)
(72) Inventor: ABRAMOV, Vladimir Semenovich, Moscow, 117526 (RU); BELENKOV, Nikolai Mikhailovich, Moscow, 127247 (RU); SCHERBAKOV, Nokolai Valentinovich, Moscow, 109377 (RU); DENISOV, Sergei Dmitrievich, Moscow, 127576 (RU); UVAROV, Lev Alexeevich, Moscow, 117279 (US)
(74) Representative: Patentanwälte Zellentin & Partner
(86) International application number: PCT/RU97/00070
(87) International publication number: WO 98/42031

(57) **Abstract**

The present invention relates to electronics and especially to semiconductors. It is as improved embodiment of a luminescent diode, intended to increase the radiated power thereof. The device concerned is realized in the form of a securing device comprising a back plate and binding screws. The luminescent diode cover resembles a polyspherical lens with a cylindrical base having guide rods relative to the positioning openings provided in the back plate. The thickness of the back plate is equal to or larger than four thicknesses of light transmitter crystal. The crystal is fastened on the flat portion of the conical reflecting surface formed on the back plate. The depth of the conical surface exceeds two thicknesses of light transmitter crystal, and the resting area of the crystal has a diameter larger than the diagonal of its lower limit, but does not exceed the value of said diagonal by more than one and a half. The volume between the cylindrical base of the cover and the upper surface of the back plate is filled with a sealing polymer (compound), and the connection point between the conductor and the isolated binding post is covered wish a layer of electroconductive glue. Luminescent diodes such as disclosed are intended to indicate the working conditions of various apparatuses and can also be used as fill-in lighting instead of incandescent lamps.

## Description

### Field of Engineering

The invention falls within the realms of electronic engineering specifically of the semiconductor devices, namely, the light-emitting diodes, and can find its application in semi-conducting engineering in the development and manufacture of light-emitting diodes used in power, railway and automobile transport, ferrous metallurgy, chemical, heavy and other industries.

### Prerequisites for Creation of Invention

Light-emitting diodes are widely used in signalling about the mode of operation of the various devices, for illumination of screens, in manufacture of information sources such as: information panels, traffic lights, travelling lines, additional signals of braking in automobiles, etc. /1/.

The use of the light-emitting diodes instead of incandescent lamps considerably increases the reliability and reduces the power consumption of the equipment. As this takes place, in many cases required are the light-emitting diodes with a wide range of colours and shades of light flow, various size and uniformity of luminous spot and different emissive power (luminous intensity).

The most important parameter of light-emitting diodes is the emissive power dependent mostly on the strength of flowing forward electrical current and the value of thermal resistance of the holder on which a crystal of light emitter is installed.

### Previous Level of Engineering

Known is a light-emitting diode with a red colour luminescence of H L M P-C100 type /2/ in which the crystal of light emitter is fixed on the holder connected to one of the electrical outlets and located in a plastic monolithic casing consisting of a hemispheric lens, 5 mm in diameter, concentrating the emission, and a cylindrical base. With the forward current being equal to 20 mA the minimum value of light intensity constitutes 0.29 Cd at an angle of vision of ±30° at half power of emission. The value of thermal resistance of the casing constitutes 210°C/W. The drawback of such light-emitting diode is low light intensity. It is caused by impossibility to increase the value of forward current strength via a unit due to considerable thermal resistance of the casing and overheating of the crystal of light emitter because the releasing heat is removed by means of a metallic outlet only. In this case a disturbance of linearity of lumen-ampere characteristic is observed. It causes stopping of a rise of luminous intensity at increasing the strength of forward current.

Also a light-emitting diode having infrared radiation of CQX 19 type /3/ is known in which a crystal of light emitter is installed on the holder of the casing TO-39. A hemispheric lens 8 mm in diameter is formed on this holder. When forward electrical current is equal to 250 mA the releasing emission power constitutes 20 mW with an angle of vision - ±20° at half power of emission. The value of thermal resistance is equal to 250...300°C/W. It presents a considerable value and does not allow to raise the emission power by increasing of strength of forward current.

### Description of Prototype

An effective red colour light-emitting diode of I N 6092 type /4/ is the most suitable for the offered light-emitting diode acc. to its technical principle. The indicated light-emitting diode, taken as a prototype, contains a metallic-glass holder with electrical outlets, a crystal of light emitter with ohmic contacts installed on the holder by means of current-transmitting glue and connected through conductor with the appropriate outlet, and also a metallic cover with a lens concentrating the emission produced by the crystal.

The allowed forward electrical current through this device is 35 mA, thermal resistance - 425°C/W, angle of vision ±18° at half emissive power while the standard value of emissive power is 5 mcd at forward current being 20 mA.

It is obviously that the drawback of this light-emitting diode is the low emissive power and considerable value of thermal resistance caused by weak scattering of heat produced by the crystal of light emitter only through the outlet on which this crystal is installed. The limitation of scattering power value does not permit the flowing of forward current of rather high strength due to a disturbance of linearity of lumen-ampere characteristic of the light-emitting diode.

### Purpose and Brief Description of Invention Principle

The set task and the aim of this invention is to increase the emissive power making it possible to vary the angle of vision of the device.

The set task is solved through the development of the offered light-emitting diode in which a cover is made in the form of a hemispheric lens with a cylindrical base having a thickness (height of cylinder) not exceeding the size of lens radius. Pins are carried out on the lower face of the cover. These pins are located in accordance with the position holes in a substrate. The substrate has a thickness equal or exceeding four thicknesses of the crystal of light emitter. The substrate has a recess with reflecting, chiefly conical, surface (truncated cone) and flat bottom on which the crystal of light emitter is installed. In this case the depth of the mounting seat of the crystal exceeds two thicknesses of the indicated crystal whereas the diameter of the mounting seat exceeds the size of diagonal of the crystal lower face, but constitutes less than one and a half of values of this size. In addition, the space between the lower face of the base and the upper surface of the substrate in the offered light-emitting diode is filled with polymeric sealing compound. At the junction of the conductor and isolated connecting outlet a layer of current-transmitting glue is applied.

### Brief Description of Drawings (Figures)

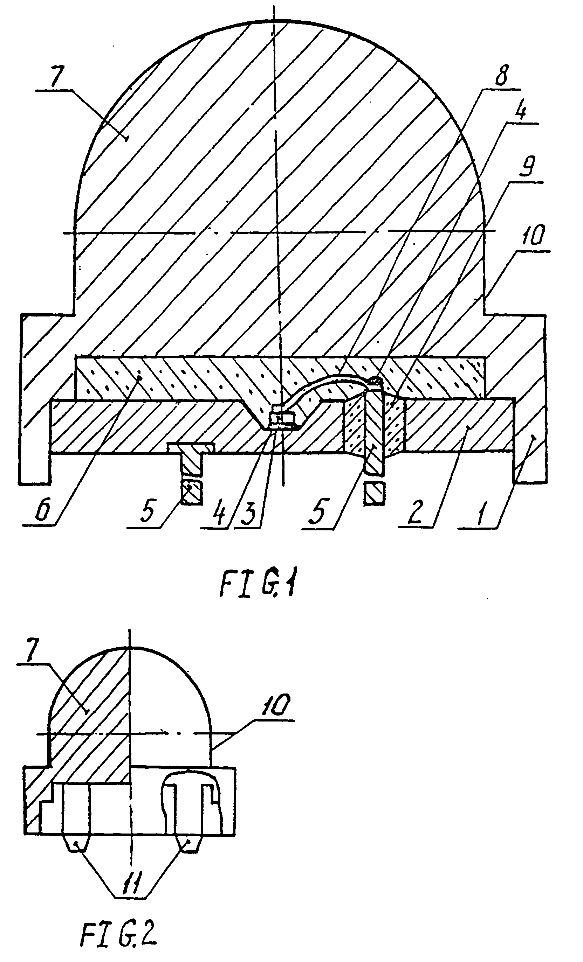

Shown in Figure 1 is a light-emitting diode, in section on an enlarged scale, in accordance with the present invention, where: 1 - cover of device, 2 - metallic substrate with a recess performed in the form of a truncated cone with the lateral surface reflecting the emission, 3 - crystal of light emitter, 4 - current-transmitting glue, 5 - electrical outlets, 6 - polymeric sealing compound, 7 - hemispheric lens, 8 - conductor, 9 - glass isolator, 10 - cylindrical base.

Shown in Figure 2 is a cover of the light-emitting diode having a hemispheric lens (7) with cylindrical base (10) and guide pins (11).

### Detailed Description of Invention

The offered light-emitting diode works as follows. When the electrical voltage which ensures the flow of forward current through the crystal of light receiver (3) is supplied to the outlets (5) of a metallic holder (2), the crystal begins to emit light. The emission from the surface of the crystal of light emitter (3) and from its lateral faces after reflecting by the conical surface falls on a layer of polymeric sealing compound (6), cylindrical base (10) and is focused by hemispheric lens (7).

The availability of polymeric sealing compound (6) and also the cylindrical base (10) having a thickness not exceeding the radius of hemispheric lens (7) ensures reduction of emission intensity losses and also the required diagram of emission directionality. Besides, the polymeric sealing compound (6) provides a water proofing of the light emitter crystal (3), point of conductor (8) connection to the crystal and also point of connection of this conductor to outlet (5), which is insulated from holder base (2) by glass insulator (10). The layer of current-transmitting glue (4), applied to the point of connection of conductor (8) to the insulated outlet (5), increases the reliability of this connection and also the light-emitting diode as a whole.

The construction of the light emitting diode with polymeric sealing compound (6), made on a basis of a metallic-glass holder with reflecting conical surface on the substrate (2) allows to use the lateral luminescence of light emitter crystal (3) and increase emission intensity (2-3 times).

The depth of reflecting truncated conical surface, on flat part of which a crystal of light emitter (3) is installed, as well as the diameter of the mounting seat for the crystal (3), make it possible to concentrate (practically fully) the emission along the optical axis of the light-emitting crystal. In this case the depth of reflecting truncated conical surface exceeds two thicknesses of the light emitter crystal (3), and the diameter of the mounting seat for the crystal of light emitter exceeds the size of diagonal of its lower face, but comprises less than one and a half of the indicated size.

Deepened mounting seat for the crystal of light emitter (3) in combination with guide pins (11) makes easier the aligment of the light emitter crystal (3) along the optical axis of the light-emitting diode.

The distance from the substrate (2) to the lower face of cylindrical base (10) may be changed by movement of the holder along the guide pins (11). It permits to regulate emission intensity at the expence of changing of the angle of vision at half emission intensity in the range from ±4 to ±50.

A metallic substrate (2) having a thickness equal or exceeding four thicknesses of the lihgt emitter crystal (3), ensures effective scattering of consumed power from lower face of substrate.

The light emitter crystals (3) with red, orange, yellow, green, blue and dark blue colours of luminescence may be used in monochromatic version of the light-etting diode.

Colour saturation and adequate perception of the information may be obtained by additional painting of a cover with appropriate colour. This paint is made y adding a pigment or dispersing agent (for example, crushed optical quartz) into it. The use of dispersing agent increases the size of luminous spot that improves the perception of luminescence without distroying the physical-chemical properties of cover material.

The increasing of emission intensity or required colour of luminescence of device is achieved by excution of reflecting conical or other consentrating surface on the substrate (2) with formation of appropriate number of outlets and installation of several crystals of light emitter of one or various colours of luminescence onto the mounting seats.

Also the substrate (2) may be dielectrical covered by a copper-nickel layer on one or two sides. In this case on the basis of copper-nickel layer a lay-out circuit may be carried out on the upper face of the substrate. This circuit is connected with the appopriate outlets (5) and ensures the installation of the light emitter crystals (3) on their mounting seats and distribution of conductors over outlets (5). The lay-out circuit is excuted in such a way that a copper-nickel layer occupies the maximum area of the substrate except for spacings which ensure the lay-out circuit. It increases reflection of emission of the light emitters crystals (3) and raises emissive power.

The availability of copper-nickel layer on the back side of the base (2) (except for outlets of connection leads (5)) ensures the lowering of thermal resistance and thereby reduces the possibility of overheating of the light emitter crystals (3).

### Example of Concrete Execution of Invention

The construction of this light-emitting diode, made in accordance with this invention contains a metallic-glass holder of steel 1 mm thick, coated with a nickel layer and connected to nickel outlets 0.55 mm in diameter. Reflecting conical surface has a depth of 0.55 mm, diameter on the substrate surface is equal to 1.6 mm, diameter of the flat mounting seat - 0.6 mm. The cover is cast in plastic - polycarbonate of "Lexan" type. The radius of a hemispheric lens is equal to 5 mm, the hight of cylindrical base is 3 mm, the distance between a substrate and base was varied within the limits of 1-3 mm. A sealing (polymeric) compound of 159-322 make was used.

A crystal emitting red light with wave 662 nm in length served as a crystal of light emitter. To install the crystal of light emitter and to coat the junction of the conductor and the isolated connecting outlet based on silver a current-transmitting glue of TOK-2 type was applied.

Descriped construction of the light-emitting diode ensures thermal resistance to be 170°C/W and increases the forward current, flowing through the light-emitting diode up to 80 mA without losses of linearity of lux-ampere characteristic. It makes it possible to obtain luminous intensity more than 1.5 Cd or emissive power more than 25 mW at current 20 and 100 mA correspondingly.

In conclusion it should be noted that we did not find the known technical decisions, directed towards the increase of emissive power of light-emitting diodes by indicated means in the scientific-technical literature and also in the patent information sources. A comparison of this invention with a selected prototype, as well as with the other technical decisions in a given field of techniques, did not reveal the technical decisions similar in distinctive features which show analogical properties.

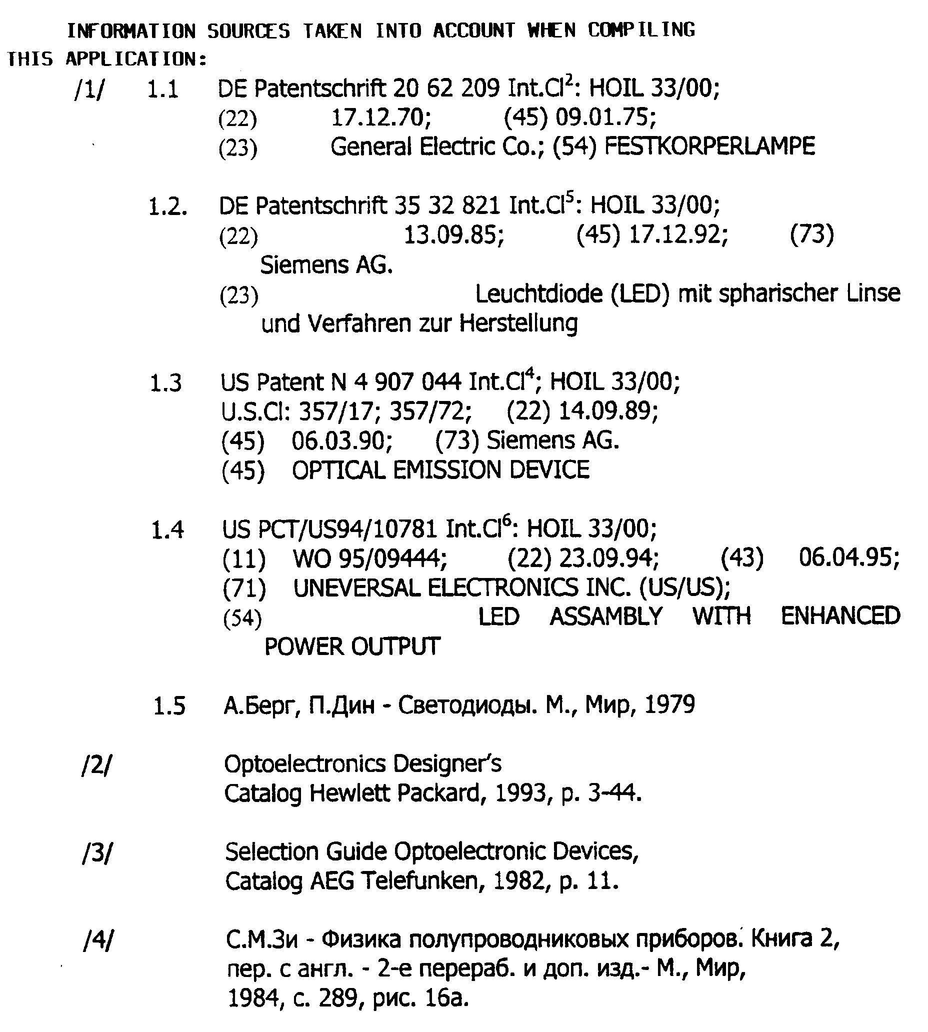

## Claims

**ALTERED INVENTION FORMULA** [received by International Bureau in July 20, 1998 (20/07/98); originally declared items 1-8 of the invention formula are substituted for new items 1-9 (2 pages)]

1. The light-emitting diode containing a crystal of light emitter, a holder with a substrate located on which is the indicated crystal with connection outlets, one of which is isolated from the substrate by glass isolator and a cover, transparent for emission with a concentrationg lens and a base, differing in the fact that the cover is executed in the form of a hemispheric lens with a cylindrical base; a lower face of the base has guide pins placed in accordance with the position holes in the substrate and the crystal of light emitter is located in a recess performed on the substrate.

2. The light-emitting diode acc. to item 1, differing in the fact that as a source of emission this light emitting diode contains several, at least, two separate semiconductor crystals with one-or many-coloured emission of optical range, located on a common substrate, and a number of the mounting seats for the crystals in the indicated recess and a number of isolated outlets corresponds to a number of crystals of the light emitters.

3. The light-emitting diode acc. to items 1-2 differing in the fact that a substrate contains a mounting seat for a crystal of light emitter in the form of recess with flat bottom and a lateral surface in the form of a body of revolution, chiefly truncated conical surface, reflecting emission.

4. The light-emitting diode acc. to items 1-3, differing in the fact that a thickness of a cylindrical base of a lens does not exceed lens radius.

5. The light-emitting diode acc. to items 1-4 differing in the fact that a substrate has a thickness equal to four and more thicknesses of light-emitter crystal.

6. The light-emitting diode acc. to items 1-5 differing in the fact that a depth of the flat mounting seat of a crystal of light-emitter exceeds two thicknesses of the crystal.

7. The light-emitting diode acc. to items 1-6 differing in the fact that a diameter of the mounting seat of the crystal of light emitter exceeds the size of diagonal of its lower face but not more than one and a half of the size of indicated diagonal.

8. The light-emitting diode acc. to items 1-7 differing in the fact that the space between a cylindrical base of the cover and the upper surface of the substrate is filled with a polymeric sealing compound.

9. The light-emitting diode acc. to items 1-8 differing in the fact that point of connection of a conductor with an isolated connecting outlets is coated with a layer of current-transmitting glue.
